# EUROPÄISCHE PATENTSCHRIFT

(11) **EP 3 227 909 B1**
(45) Veröffentlichungstag und Bekanntmachung des Hinweises auf die Patenterteilung: **28.07.2021**
(21) Anmeldenummer: 15759421.9
(22) Anmeldetag: 19.08.2015
(51) Int. Cl.: H01L 21/67

(54) **SUBSTRATSTAPELHALTERUNG, CONTAINER UND VERFAHREN ZUR TRENNUNG EINES SUBSTRATSTAPELS**
SUBSTRATE STACK HOLDER, CONTAINER AND METHOD FOR SEPARATING A SUBSTRATE STACK
ÉLÉMENT DE RETENUE DE PILE DE SUBSTRATS, CONTENEUR ET PROCÉDÉ DE SÉPARATION D'UNE PILE DE SUBSTRATS

(30) Priorität: 05.12.2014 DE 102014118017
(43) Veröffentlichungstag der Anmeldung: 11.10.2017
(73) Patentinhaber: EV Group E. Thallner GmbH, 4782 St. Florian am Inn (AT)
(72) Erfinder: FEHKÜHRER, Andreas, A-4973 Senftenbach (AT)
(74) Vertreter: Schneider, Sascha
(86) Internationale Anmeldenummer: PCT/EP2015/069082
(87) Internationale Veröffentlichungsnummer: WO 2016/087062

(56) Entgegenhaltungen:
- EP-A2- 0 867 917
- US-A- 5 897 743
- US-A1- 2005 000 649
- US-A1- 2014 020 846

## Beschreibung

Die Erfindung betrifft eine Substratstapelhalterung, einen Container aufweisend solche Substratstapelhalterungen und ein Verfahren zur Trennung eines Substratstapels.

Im Stand der Technik wird zur Erzeugung von SOI- (silicon on insulator) Wafern bzw. Strukturen vorzugsweise ein so genannter Schichtübertragungsprozess (engl.: layer transfer process) verwendet. Druckschrift US 2015/0231790 A1 offenbart eine Vorrichtung zur Trennung zweier Substrate.

In einem ersten Prozessschritt wird eine Ionenart, die sich unter erhöhten Temperaturen zu einem Gas formiert, durch einen Implantationsprozess in ein erstes Halbleitersubstrat eingebracht. In einem weiteren Prozessschritt erfolgt die Oxidation des ersten Halbleitersubstrats. In einem weiteren Prozessschritt erfolgt die Verbondung des oxidbeschichteten ersten Halbleitersubstrats mit einem zweiten Substrat. Nach dem Bondvorgang erfolgt eine thermische Behandlung des erzeugten Substratstapels. Die Wärmebehandlung führt zu einem Bruch entlang des ersten Halbleitersubstrats. Nach dem Bruch haftet die so erzeugte Schicht mit ihrer Oxidschicht immer noch am zweiten Halbleitersubstrat, während der Hauptteil des ersten Halbleitersubstrats abgenommen werden kann. Dieser Prozess ist insbesondere unter dem Namen Smart Cut-Prozess bekannt. Der Smart Cut-Prozess wird insbesondere in der Druckschrift US5374564A beschrieben.

Ein häufig auftretendes Problem stellt im Stand der Technik die Wiedervereinigung der kurz zuvor voneinander getrennten Substratstapelteile dar. Die erneute Trennung der beiden Substratstapelteile voneinander ist relativ schwer und aufwendig.

Es ist daher die Aufgabe der vorliegenden Erfindung, eine verbesserte Substratstapelhalterung sowie ein verbessertes Verfahren zur Trennung eines Substratstapels zur Verfügung zu stellen.

Diese Aufgabe wird mit den Gegenständen der nebengeordneten Ansprüche gelöst. Vorteilhafte Weiterbildungen der Erfindung sind in den Unteransprüchen angegeben.

Der erfindungsgemäße Gedanke besteht darin, eine Substratstapelhalterung für einen Substratstapel zu konstruieren, die einerseits einen Trennungsvorgang, insbesondere mechanisch, unterstützt und andererseits verhindert, dass die Substratstapelteile nach der Trennung miteinander kontaktieren. Dadurch kann vorteilhaft ein ungewolltes nachträgliches Verbinden der Substratstapelteile verhindert werden. Die erfindungsgemäße Substratstapelhalterung weist eine Halte- und Separiereinrichtung und eine Fixiereinrichtung auf. Die Halte- und Separiereinrichtung dient der Positionierung und Fixierung des Substratstapels vor dem Trennprozess und ist damit für die Vorfixierung verantwortlich. Außerdem dient sie der Separierung der Substratstapelteile nach dem Trennvorgang. Die Fixiereinrichtung weist Elemente zur Fixierung der beiden Substratstapelteile nach dem Trennungsprozess in einer separierten Position auf und ist daher für die Nachfixierung verantwortlich.

Im Folgenden soll unter Trennung des Substratstapels das Aufspalten des Substratstapels in die Substratstapelteile verstanden werden, insbesondere im Rahmen eines Schichttransferprozesses, aber nicht darauf beschränkt. Unter Separierung der Substratstapelteile soll das voneinander Wegbewegen der Substratstapelteile verstanden werden, so dass sich die Substratstapelteile nach der Trennung des Substratstapels nicht mehr berühren können.

### Die Halte- und Separiereinrichtung

Im weiteren Verlauf wird zuerst die Halte- und Separiereinrichtung als erstes erfindungsgemäßes Konstruktionsmerkmal beschrieben. Sie ist so auszulegen, dass sie in der Lage ist, einen Substratstapel bis zum eigentlichen Trennvorgang in Position zu halten. Außerdem ist sie derart ausgebildet, dass sie die Substratstapelteile nach dem Trennvorgang voneinander separiert, sodass die Substratstapelteile sich nicht berühren. Die Substratstapelhalterung bzw. die Halte-und Separiereinrichtung ist bevorzugt zur vertikalen Aufnahme des Substratstapels ausgebildet. Durch die vertikale Ausrichtung kann vorteilhaft erstens Bauraum eingespart und zweitens das Entladen bzw. Beladen der Substratstapelhalterung vereinfacht werden. Es ist alternativ möglich, dass der Substratstapel in einer anderen Ausrichtung, insbesondere in horizontaler Ausrichtung, aufgenommen wird.

Die Halte- und Separiereinrichtung kann in einer bevorzugten Ausführungsform mindestens einen, insbesondere keilförmig ausgebildeten, Klemmarm aufweisen, der den Substratstapel radial von außen im Verbindungsbereich festklemmbar ausgebildet ist. Der Keilwinkel ist insbesondere größer als 15°, vorzugsweise größer als 45°, noch bevorzugter größer als 75°, am bevorzugtesten größer als 105°, am allerbevorzugtesten größer als 135° ist. Mit Verbindungsbereich ist derjenige Bereich gemeint, der zwischen den beiden Substraten angeordnet ist und durch den die beiden Substrate miteinander zum Substratstapel verbunden sind. Der Klemmarm kann eine Kraft radial von außen auf den Substratstapel im Verbindungsbereich (oder in einer neben und/oder parallel zum Verbindungsbereich verlaufenden Schwächungsebene) aufbringen, sodass der Substratstapel in seiner Position stabil gehalten werden kann. Durch die keilförmige Ausbildung des Klemmarms kann vorteilhaft ein besonders stabiles Halten des Substratstapels erreicht werden. Außerdem unterstützt die Keilform in Verbindung mit der Klemmkraft die Separierung der getrennten Substratstapelteile voneinander.

In einer besonders bevorzugten Ausführungsform besitzt der Klemmarm ein Gelenk. Der Klemmarm kann mit Hilfe des Gelenks über den Substratstapel geklappt werden und, insbesondere durch sein Eigengewicht, den Substratstapel fixieren bzw. die Separierung der Substratstapelteile bewirken. Der Klemmarm wird insbesondere durch eine Feder oder durch ein anderes Maschinenelement so unter Spannung gesetzt, dass ein leichter Druck auf den Substratstapel ausgeübt wird. Möglich wäre auch ein motorisierter Klemmarm. Es kann alternativ ein oben beschriebener mechanischer Klemmarm, insbesondere mit Feder zur automatischen Rückstellung, eingebaut werden, der insbesondere durch eine Krafteinwirkung einer externen Maschine, betätigt wird.

In einer anderen bevorzugten Ausführungsform besteht der Klemmarm aus einem elastischen Werkstoff, insbesondere aus Kunststoff, bevorzugter aus Metall, noch bevorzugter aus einem Karbonverbundwerkstoff, und ist nicht über ein Gelenk sondern über ein Festlager fixiert. In einer ganz besonderen bevorzugten Ausführungsform ist der Klemmarm aus einer Keramik, insbesondere aus Siliziumnitrid (Si3N4), gefertigt. Derartige Keramiken sind zwar relativ spröde, dafür allerdings inert, und relativ unempfindlich gegen höhere Temperaturen. Da auf den Klemmarm keine besonderen hohen, mechanischen Belastungen wirken, können derartige spröde Keramiken eingesetzt werden. Durch die Elastizität des Klemmarmmaterials kann der Klemmarm zumindest einige Millimeter angehoben werden, sodass die Beladung und/oder Entladung des Substratstapels ermöglicht wird. Der fixierende Teil des Klemmarms kann dabei um mehr als 0.1 mm, vorzugsweise um mehr als 1 mm, noch bevorzugter um mehr als 10 mm anheben. Der E-Modul des Werkstoffs liegt dabei zwischen 1 GPa und 1000 GPa, bevorzugt zwischen 10 GPa und 1000 GPa, mit größerem Vorzug zwischen 100 GPa und 1000 GPa, mit größtem Vorzug zwischen 500 GPa und 1000 GPa, am bevorzugtesten zwischen 800 GPa und 1000 GPa.

In einer bevorzugten Ausführungsform weist die Halte- und Separiereinrichtung ein, insbesondere keilförmig ausgebildetes, Podest auf, auf das der Substratstapel in seinem Verbindungsbereich, insbesondere hochkant, auflegbar ist. Vorzugsweise weist das Podest einen der Keilwinkel größer als 15°, vorzugsweise größer als 45°, noch bevorzugter größer als 75°, am bevorzugtesten größer als 105°, am allerbevorzugtesten größer als 135° auf. Die Form eines, den Substratstapel nicht umschließenden, Podests verbessert die Trennung und Entfernung der Substratstapelteile in Richtung Fixierung. Denn die beiden Substratstapelteile haben nach deren Trennung die Möglichkeit der Bewegung in Richtung der Fixierung, da sie an ihrer Unterseite nicht vollumfänglich umschlossen sind.

Durch die keilförmige Ausbildung des Podests kann weiterhin vorteilhaft ein besonders stabiles Halten des Substratstapels erreicht werden. Außerdem unterstützt die Keilform in Verbindung mit der Gravitationskraft die Separierung der getrennten Substratstapelteile voneinander. Durch die hochkantige Anordnung des Substratstapels kann vorteilhaft eine besonders effiziente Separierung der Substratstapelteile voneinander erfolgen.

Das Podest ist vorzugsweise so konstruiert, dass es dem Substratstapel im nicht getrennten Zustand genug Halt gibt, und zugleich eine möglichst leichte, insbesondere aufgrund der Gravitationskraft selbstständige, Separierung der beiden Substratstapelteile nach der Trennung erlaubt.

Podest und Klemmarm können voneinander getrennt konstruiert und montiert werden. Denkbar ist allerdings auch, dass Klemmarm und Podest zwei, insbesondere elastisch klemmend wirkende, Abschnitte eines zusammenhängenden Bauteils darstellen.

Die erfindungsgemäße Ausführungsform mit Klemmarm und Podest eignet sich insbesondere für vertikal gelagerte Substratstapelhalter, da der Substratstapel entsprechend am Podest abgelegt und über den Klemmarm fixiert werden kann. In einer anderen Ausführungsform ist es möglich, eine symmetrische Halterung zu konstruieren, wobei die Halte- und Separiereinrichtung als eine symmetrische Gabel ausgebildet ist, deren zwei Zinken zwei symmetrische Klemmarme darstellen. Diese Gabel ist derart elastisch ausgelegt, dass der Substratstapel durch leichten Druck in der Gabel fixiert werden kann und erst durch die Trennung von dieser seitlich abfällt.

Die Halte- und Separiereinrichtung kann insbesondere aus einem oder mehreren der folgenden Materialien gefertigt werden:
- Keramik, insbesondere
   ∘ Nitridkeramik insbesondere,
      □ Siliziumnitrid (Si3N4)
   ∘ Karbidkeramik oder
   ∘ Anorganisch nichtmetallische Gläser, insbesondere
      □ Nichtoxidische Gläser, oder
      □ Oxidische Gläser, insbesondere
- Silikatische Gläser oder
- Boratgläser oder
- Phosphatische Gläser
- Metall, insbesondere
   ∘ Refraktärmetall, insbesondere
      □ W, Nb, Ta, Ti, Zr, Hf, V, Cr, Mo
   ∘ Höher schmelzende Reinmetalle, insbesondere
      □ Cu, Al, Ni, Pt
   ∘ Stahl
- Legierungen, insbesondere
   ∘ Metalllegierungen
- Kunststoff, insbesondere
   ∘ Duroplast

### Die Fixiereinrichtung

Die Fixiereinrichtung ist das zweite wesentliche Konstruktionsmerkmal der erfindungsgemäßen Substratstapelhalterung.

Die Fixiereinrichtung ist so konstruiert, dass sie den Substratstapel und damit die Substratstapelteile umgibt. Die Fixiereinrichtung weist erfindungsgemäß auf jeder Seite des Substratstapels mindestens einen parallel zum Substratstapel angeordneten Gerüstträger mit Fixierelementen zur Aufnahme und Befestigung der separierten Substratstapelteile auf, um die Substratstapelteile nach der Trennung an den Gerüstträgern zu fixieren. Durch die sofortige Fixierung wird eine ungewollte Kontaktierung der Substratstapelteile nach deren Trennung vermieden, die Substratstapelteile bleiben voneinander getrennt und können, insbesondere nach dem Ende eines Wärmebehandlungsprozesses, aus der Substratstapelhalterung entnommen werden.

In einer bevorzugten Ausführungsform sind die Fixierelemente als mit Vakuumleitungen verbundene Ansaugöffnungen zum Ansaugen der Substratstapelteile ausgebildet. Durch das Ansaugen kann vorteilhaft eine Beschädigung der Substratstapelteile weitgehend verhindert werden. Die Ansaugöffnungen sind an, insbesondere zwei, voneinander unabhängigen, Vakuumleitungen, die insbesondere in den Gerüstträgern verbaut sind, angeschlossen. Jede der Vakuumleitungen ist insbesondere durch eine Vakuumpumpe und/oder entsprechende Fluidelemente getrennt von der jeweils anderen Vakuumleitung ansteuerbar. Die separate Ansteuerung der Vakuumleitung erlaubt die separate Entnahme der einzelnen Substratstapelteile. In besonderen Ausführungsformen können fluiddynamische Bauteil so vor die einzelnen Vakuumleitungen geschaltet werden, dass eine simultane Evakuierung beider Vakuumleitungen und damit eine simultane Saugwirkung auf beide Substratstapelteile erfolgen können.

In jeder Vakuumleitung kann insbesondere eine Druck kleiner als 1 bar, vorzugsweise kleiner als 800 mbar, noch bevorzugter kleiner als 500 mbar, am bevorzugtesten kleiner als 200 mbar eingestellt werden. Es ist ein wichtiger erfindungsgemäßer Aspekt, die Substratstapelteile nach der erfindungsgemäßen Trennung nur sehr gering zu belasten. Daher werden in den Vakuumleitungen vorzugsweise nur Drücke leicht unterhalb dem Atmosphärendruck eingestellt. Sollte die erfindungsgemäße Ausführungsform in einer Überdruckumgebung verwendet werden, ist der Druck in der Vakuumleitung daher insbesondere um 200 mbar, bevorzugter um 500 mbar, noch bevorzugter um 800 mbar geringer als der Umgebungsdruck. Die Vakuumleitungen können nachfolgend auch mit Überdruck beaufschlagt werden, um die Substratstapelteile effizienter von der Fixierung zu lösen. Das ist insbesondere dann sinnvoll, wenn sich die erfindungsgemäße Ausführungsform in einer Überdruckkammer befindet, in der der Druck in den Vakuumleitungen größer sein muss als der Kammerdruck der Überdruckkammer. Die Vakuumleitungen können in diesem Fall einen Druck zwischen 1 bar und 10 bar, vorzugsweise zwischen 1 bar und 8 bar, noch bevorzugter zwischen 1 bar und 5 bar, am bevorzugtesten zwischen 1 bar und 3 bar, am allerbevorzugtesten zwischen 1 bar und 2 bar ertragen. Denkbar ist die Verwendung von kleinen Dichtringen oder einem Saugnapf ähnlichen Kontaktierungen, die an die Ansaugöffnungen anschließen, um einen optimalen Kontakt zwischen dem Substratstapelteil und der Vakuumleitung herzustellen. Derartige Dichtungselemente sollten insbesondere elastisch und/oder vakuumdicht sein und/oder eine hohe Temperaturstabilität besitzen.

Der E-Modul derartiger Dichtungen ist insbesondere kleiner als 200 GPa, vorzugsweise kleiner als 100 GPa, noch bevorzugter kleiner als 1 GPa, am bevorzugtesten kleiner als 100 MPa, am allerbevorzugtesten kleiner als 10 MPa. Die Dichtigkeit ist insbesondere größer als 1 mbar^{∗}l/s, vorzugsweise zwischen 2 und 10 mbar^{∗}l/s, noch bevorzugter zwischen 4 und 10 mbar^{∗}l/s, am bevorzugtesten zwischen 6 und 10 mbar^{∗}l/s, am allerbevorzugtesten zwischen 8 und 10 mbar^{∗}l/s. Diese Dichtigkeitswerte werden von den verwendeten Werkstoffen insbesondere auch bei erhöhten Temperaturen erreicht, sodass eine sichere Vakuumfixierung in jedem Temperaturbereich gegeben ist. Die Werkstoffe sind insbesondere temperaturstabil bis über 100°C, noch bevorzugter bis über 250°C, noch bevorzugter bis über 500°C, am bevorzugtesten bis über 750°C, am allerbevorzugtesten bis über 1000°C.

In einer alternativen Ausführungsform besitzt die Fixiereinrichtung elektrostatische Fixierelemente. Die elektrostatischen Fixierelemente bestehen insbesondere aus elektrisch leitfähigen Bauteilen, insbesondere Platten, die gegen die Gerüstträger elektrisch isoliert wurden. Die elektrisch leitfähigen Bauteile können durch entsprechende Zuleitungen auf ein wohldefiniertes Potential gesetzt werden. Die elektrisch leitfähigen Bauteile sind bei Bedarf vollautomatisch vom Stromkreis trennbar. Die Verwendung derartiger elektrostatischer Fixierelemente setzt Substratstapelteile mit einem entsprechenden physikalischen Eigenschaften und einem entsprechenden Verhalten in Bezug auf Elektrostatik voraus.

In der einfachsten Ausführungsform handelt es sich bei den elektrisch leitfähigen Bauteilen um kleine Zylinder. Die Zylinder besitzen eine im Vergleich zu ihrem charakteristischen, mittleren Durchmesser bzw. mittlerer Abmessung eine entsprechend geringe Dicke und können daher auch als Scheiben bezeichnet werden. Die Grundfläche der Zylinder ist entweder ein kreisförmiges Segment, ein halbkreisförmiges Segment, ein teilkreisförmiges Segment mit beliebigem Segmentwinkel, ein Rechteck, im speziellen ein Quadrat, oder jede beliebige andere geometrische Figur. Die unterschiedlichen geometrischen Figuren besitzen unterschiedliche, charakteristische Abmessungen. Im weiteren Verlauf wird der Ausdruck "Abmessung" als Synonym für die jeweils, der geometrischen Figur zugeschriebenen, charakteristischen Abmessung verwendet. So ist darunter für einen Kreis der Durchmesser, für ein Rechteck der Mittelwert seiner zwei Seiten etc. zu verstehen. Die Abmessung ist insbesondere kleiner als 10cm, vorzugsweise kleiner als 8cm, noch bevorzugter kleiner als 6cm, am bevorzugtesten kleiner als 4cm, am allerbevorzugtesten kleiner als 2 cm.

Die Dicke des Zylinders ist insbesondere kleiner als 6cm, vorzugsweise kleiner als 4cm, noch bevorzugter kleiner als 2cm, am bevorzugtesten kleiner als 1cm, am allerbevorzugtesten kleiner als 0.5cm. In einer ganz besonders bevorzugten Ausführungsform sind immer jeweils zwei Platten als Elektroden zusammen geschalten und liegen auf gegenpoligem Potential. Dadurch erfährt das zu beeinflussende Substratstapelteil eine entsprechend gegenpolige Influenz. Das angelegte Potential an einer derartigen Elektrode liegt vorzugsweise zwischen -30.000V und 30.000V, vorzugsweise zwischen -20.000V und 20.000V, noch bevorzugter zwischen -10.000V und 10.000V, am bevorzugtesten zwischen -5000V und 5000V, am allerbevorzugtesten zwischen -3000V und 3000V.

In einer besonderen bevorzugten Ausführungsform sind die Elektroden vollumfänglich mit einem Isoliermaterial umgeben, sodass keine Entladung an die Umgebung erfolgen kann. Als Isoliermaterial kommen insbesondere Dielektrika in Frage, vorzugsweise Kunststoffe, noch bevorzugter Keramiken, die entsprechend hohen Temperaturen standhalten können.

In einer weiteren bevorzugten Ausführungsform sind schaltbare Oberflächen am Gerüstträger vorhanden. Unter einer schaltbaren Oberfläche versteht man erfindungsgemäß eine Oberfläche, die ihre Adhäsionseigenschaft, besonders die Adhäsionsfähigkeit, in Folge eines Impulses, insbesondere eines elektrischen Signals, verändern kann. Die Adhäsion wird vorzugsweise über die Energie pro Flächeneinheit definiert, die notwendig ist, um zwei miteinander verbundene Oberflächen voneinander zu trennen. Die Energie wird dabei in J/m2 angegeben.

Die Energie pro Einheitsfläche ist dabei im deaktivierten Zustand der schaltbaren Oberfläche, daher im Zustand in dem die Adhäsion ein Minimum einnehmen soll, geringer als 2.5 J/m², mit Vorzug kleiner als 0.1 J/ m², mit größerem Vorzug kleiner als 0.01 J/ m², mit größtem Vorzug kleiner als 0.001 J/ m², mit allergrößtem Vorzug kleiner als 0.0001 J/ m², am bevorzugtesten kleiner als 0.00001 J/ m². Die Energie pro Einheitsfläche ist im aktivierten Zustand der schaltbaren Oberfläche, daher im Zustand in dem die Adhäsion ein Maximum einnehmen soll, größer als 0.00001 J/ m², mit Vorzug größer als 0.0001 J/ m², mit größerem Vorzug größer als 0.001 J/ m², mit größtem Vorzug größer als 0.01 J/ m², mit allergrößtem Vorzug größer als 0.1 J/ m², am bevorzugtesten größer als 1 J/ m².

In einer weiteren bevorzugten Ausführungsform sind mechanische Klemmen am Gerüstträger fixiert, die über mechanische und/oder pneumatische und/oder hydraulische Steuerung geschalten werden können.

Die Fixiereinrichtung bzw. die Gerüstträger können aus einem oder mehreren der folgenden Materialien gefertigt werden:
- Keramik, insbesondere
   ∘ Nitridkeramik insbesondere,
      □ Siliziumnitrid (Si3N4)
   ∘ Karbidkeramik oder
   ∘ Anorganisch nichtmetallische Gläser, insbesondere
      □ Nichtoxidische Gläser, oder
      □ Oxidische Gläser, insbesondere
- Silikatische Gläser oder
- Boratgläser oder
- Phosphatische Gläser
- Metall, insbesondere
   ∘ Refraktärmetall, insbesondere
      □ W, Nb, Ta, Ti, Zr, Hf, V, Cr, Mo
   ∘ Höher schmelzende Reinmetalle, insbesondere
      □ Cu, Al, Ni, Pt
   ∘ Stahl
- Legierungen, insbesondere
   ∘ Metalllegierungen
- Kunststoff, insbesondere
   ∘ Duroplast

### Container

Ein weiterer Gegenstand der vorliegenden Erfindung gemäß einem anderen Anspruch betrifft einen Container, aufweisend eine Vielzahl an, insbesondere horizontal nebeneinander angeordneten, Substratstapelhalterungen nach einer der zuvor beschriebenen Ausführungsformen. Alle zuvor für die Substratstapelhalterung beschriebenen Merkmale und Ausführungsbeispiele sollen sinngemäß auch für den erfindungsgemäßen Container gelten.

Mehrere Substratstapelhalterungen können in einem Container gelagert bzw. angeordnet werden. Denkbar sind vor allem Container aus Keramik, insbesondere Glas, noch bevorzugter Borosilikatglas. Der Container kann auch jede andere Art von Behältnis sein, welches dazu geeignet ist, die Substratstapelhalterungen aufzunehmen. Der Container ist vorzugsweise offen, um die Substratstapel automatisch beladen und entladen zu können. Die Halterungen und Fixierungen der Container bestehen aus hitzebeständigem Material. Dadurch wird es erfindungsgemäß ermöglicht, die Trennung in einem Ofen, insbesondere einem Durchlaufofen, durchzuführen und die beiden voneinander getrennten Substratstapelteile sofort durch die Fixierung, noch im Ofen, festzuhalten und damit bleibend voneinander zu trennen. Eine erneute Adhäsion der beiden Substratstapelteile durch Kontaktierung unterbleibt dadurch.

Der Container kann aus einem oder mehreren der folgenden Materialien gefertigt werden:
- Keramik, insbesondere
   ∘ Nitridkeramik insbesondere,
      □ Siliziumnitrid (Si3N4)
   ∘ Karbidkeramik oder
   ∘ Anorganisch nichtmetallische Gläser, insbesondere
      □ Nichtoxidische Gläser, oder
      □ Oxidische Gläser, insbesondere
- Silikatische Gläser oder
- Boratgläser oder
- Phosphatische Gläser
- Metall, insbesondere
   ∘ Refraktärmetall, insbesondere
      □ W, Nb, Ta, Ti, Zr, Hf, V, Cr, Mo
   ∘ Höher schmelzende Reinmetalle, insbesondere
      □ Cu, Al, Ni, Pt
   ∘ Stahl
- Legierungen, insbesondere
   ∘ Metalllegierungen
- Kunststoff, insbesondere
   ∘ Duroplast

### Das Verfahren

Ein weiterer Gegenstand der vorliegenden Erfindung gemäß einem anderen nebengeordneten Anspruch betrifft ein Verfahren zur Trennung eines Substratstapels, insbesondere eines Schichttransferstapels. Alle zuvor für die Substratstapelhalterung und den Container beschriebenen Merkmale und Ausführungsbeispiele sollen sinngemäß auch für das erfindungsgemäße Verfahren gelten und umgekehrt.

Das erfindungsgemäße Verfahren besteht in der Beladung, Trennung, Fixierung und Entladen eines Substratstapels, insbesondere eines Schichttransferstapels, in einer bevorzugten Ausführungsform eines Schichttransferstapels, bzw. von Substratstapelteilen. In weiterer Folge soll ein Schichttransferstapel als Beispiel für den erfindungsgemäßen Prozess dienen. Die Auswahl eines Schichttransferstapels ist allerdings in keiner Weise einschränkend für den erfindungsgemäßen Prozess.

In einem erfindungsgemäßen ersten Prozessschritt wird der Substratstapel in einen Substratstapelhalter geladen und in der Substratstapelhalterung gehaltert, wobei es sich erfindungsgemäß um eine Substratstapelhalterung gemäß den obigen Ausführungen handelt. Insoweit wird auf die obigen Ausführungen verwiesen. Das Laden erfolgt entweder manuell oder mit einer halb- bzw. vollautomatischen Anlage. In einer Hochvolumenproduktion erfolgt die Beladung insbesondere mit einem Roboter. In einer beispielhaften Ausführungsform wird der Substratstapel auf einem wie oben beschriebenen Podest positioniert. Insbesondere kann ein wie oben beschriebener Klemmarm den Substratstapel fixieren, vorzugsweise zumindest teilweise, noch bevorzugter überwiegend, noch bevorzugter ausschließlich aufgrund seines Eigengewichts und/oder seiner Vorspannung.

In einer bevorzugten Ausführungsform wird der Substratstapel zwischen zwei Zinken einer elastisch ausgebildeten Gabel eingeklemmt bzw. gehaltert. So arbeitet der Roboter vorzugsweise nur gegen den elastischen Widerstand der Gabel und klemmt den Substratstapel zwischen den beiden Zinken der Gabel ein. Die Innenseite der Gabelzinken sind dabei vorzugsweise keilförmig ausgebildet. Durch diese bevorzugte Ausführungsform ergibt sich ein bevorzugter Prozessfluss, da auf die Ansteuerung eines über ein Gelenk drehbaren Klemmarms verzichtet werden kann. Daraus ergeben sich verkürzte und daher optimierte Prozesszeiten. Ein derartiger erfindungsgemäßer Prozessschritt zur Beladung Substratstapelhalterung wird insbesondere mehrmals ausgeführt. Die entsprechenden Substratstapelhalterungen sind vorzugsweise hintereinander gereiht, noch bevorzugter in einem Container, gelagert, um in einem weiteren Prozessschritt in einen Ofen, insbesondere einen Durchlaufofen, transportiert werden zu können.

In einem erfindungsgemäßen zweiten Prozessschritt wird die Substratstapelhalterung mit dem Substratstapel einer Wärmebehandlung unterzogen. Die Wärmebehandlung findet bevorzugt in einem Ofen, vorzugsweise in einem Durchlaufofen, statt. Der Substratstapel wird dabei auf eine Temperatur größer 25°C, vorzugsweise größer 100°C, noch bevorzugter größer 250°C, am bevorzugtesten größer 500°C, am aller bevorzugtesten größer 750°C geheizt. Die Teile der Substratstapelhalterung sind aus Werkstoffen gefertigt, die keine Schädigung bei entsprechend hohen Temperaturen erleiden, insbesondere aus den oben beschriebenen Materialien. Vorzugsweise verwendet man Keramiken, insbesondere Glaskeramiken, Siliziumnitrid, Siliziumkarbid etc. Derartige Werkstoffe besitzen eine relativ schlechte Wärmeleitfähigkeit, sodass der Substratstapel beim Wärmebehandlungsprozess durch die Halterung, in Bezug auf die Wärmeleitung, thermisch isoliert werden kann.

Um eine entsprechende Durchwärmung des Substratstapels zu erzielen, wird insbesondere der Raum, indem der erfindungsgemäße Prozess stattfindet, mit einem Gas, insbesondere einem Gas mit entsprechend hoher Wärmeleitfähigkeit, gespült. Die Wärmeleitfähigkeit des Gases ist größer als 0 W/(m^{∗}K), vorzugsweise größer als 0.01 W/(m^{∗}K), noch bevorzugter größer als 0.1 W/(m^{∗}K), am bevorzugtesten größer als 1 W/(m^{∗}K). Die Wärmeleitfähigkeit von Helium liegt ca. zwischen 0.15 W/(m^{∗}K) und 0.16 W/(m^{∗}K). Im erfindungsgemäßen zweiten Prozessschritt findet die Trennung des Substratstapels in die beiden Substratstapelteile statt. Die Durchwärmung kann allerdings auch in einer Vakuumumgebung stattfinden. Der Substratstapel wird dann, vorzugsweise durch Infrarotstrahler, erwärmt oder die Wärme wird durch Wärmekonvektion über die Halte- bzw. Separiervorrichtung eingebracht.

In einem erfindungsgemäßen dritten Prozessschritt fallen die Substratstapelteile voneinander ab. Der Separierprozess wird insbesondere durch ein entsprechend geformtes Podest und/oder einen entsprechend geformten Klemmarm bewirkt bzw. zumindest unterstützt. Insbesondere tragen keilförmige geformte Podeste und Klemmarme zur verbesserten Separierung der beiden Substratstapelteile bei. In der erfindungsgemäßen Ausführungsform gelangen die Substratstapelteile in die Nähe der Gerüstträger, in und/oder an denen sich die Fixierelemente befinden. Die Fixierelemente fixieren die Substratstapelteile und verhindern eine Wiedervereinigung der durch den Trennprozess entstandenen, extrem reaktiven, sauberen und hochadhäsiven Oberflächen. Die Trennung der Substratstapelteile wird dadurch über den Wärmebehandlungsprozess hinaus aufrechterhalten.

In einem erfindungsgemäßen vierten Prozessschritt erfolgt die Entladung der voneinander getrennt gehaltenen Substratstapelteile. Die Entladung erfolgt dabei wiederum vorzugsweise durch einen Roboter, daher vollautomatisch. Denkbar ist alternativ auch eine manuelle oder semiautomatische Entladung.

Ein weiterer Gegenstand der vorliegenden Erfindung gemäß einem anderen nebengeordneten Anspruch betrifft eine Verwendung einer Substratstapelhalterung gemäß einer der zuvor beschriebenen Ausführungsformen zur Trennung eines Substratstapels, insbesondere gemäß einem wie oben beschriebenen erfindungsgemäßen Verfahren. Zur Vermeidung von Wiederholungen wird auf die obigen Ausführungen verwiesen.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
Figur 1a, Figur 1b und Figur 1c zeigen verschiedene Schritte eines Prozesses zur Herstellung und Trennung eines Schichttransferstapels,
Figur 2a zeigt einen Schnitt durch die Vorderansicht einer beispielhaften Substratstapelhalterung mit einem Substratstapel,
Figur 2b zeigt einen Schnitt durch die Vorderansicht der Substratstapelhalterung gemäß Figur 2a mit getrennten Substratstapelteilen,
Figur 3 zeigt eine Seitenansicht einer Substratstapelhalterung gemäß einer beispielhaften Ausführungsform,
Figur 4 zeigt eine Seitenansicht einer Substratstapelhalterung gemäß einer anderen beispielhaften Ausführungsform
Figur 5 zeigt eine Seitenansicht einer Substratstapelhalterung gemäß einer anderen beispielhaften Ausführungsform,
Figur 6 zeigt eine Seitenansicht einer Substratstapelhalterung gemäß einer anderen beispielhaften Ausführungsform und
Figur 7 zeigt einen Schnitt einer Seitenansicht einer Ausführungsform eines erfindungsgemäßen Containers.

In den Figuren sind Vorteile und Merkmale der Erfindung mit diese jeweils identifizierenden Bezugszeichen gemäß Ausführungsformen der Erfindung gekennzeichnet, wobei Bauteile bzw. Merkmale mit gleicher und/oder gleich wirkender Funktion mit identischen Bezugszeichen gekennzeichnet sein können.

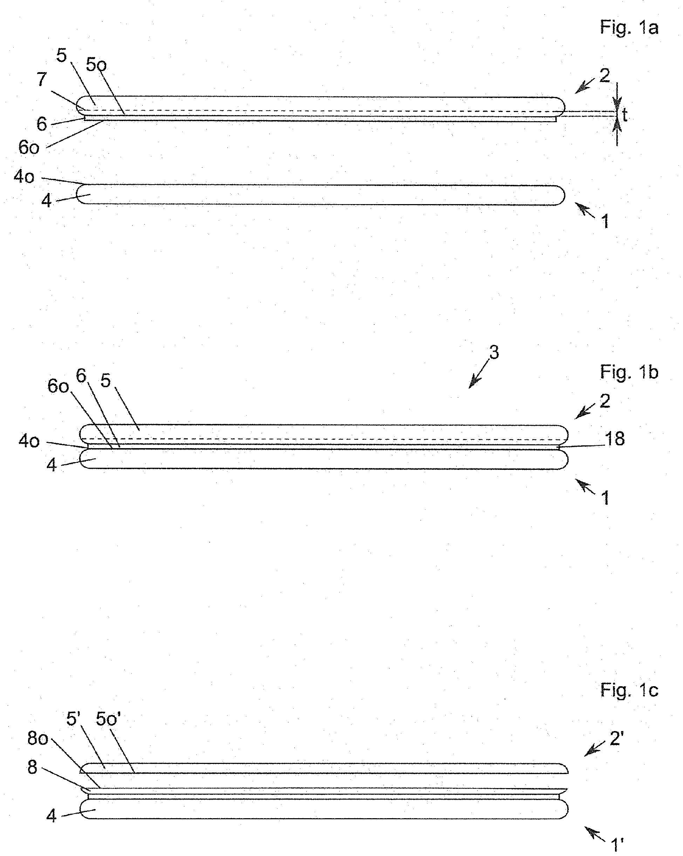

Figur 1a, Figur 1b und Figur 1c zeigen schematisch zeitlich aufeinanderfolgende Schritte eines Prozesses zur Herstellung und Trennung eines Schichttransferstapels 3.

In einem ersten Prozessschritt erfolgt die Oxidation eines Halbleitersubstrats 2. Die erzeugte Oxidschicht 6 kann dann noch in weiteren Prozessschritten geschliffen und gedünnt werden. Im Speziellen erfolgt durch derartige Prozesse auch eine Reduktion der Rauheit der Oxidoberfläche 6o, welche für den späteren Fusionsbondprozess notwendig ist. Die Oxidschicht 6 kann durch derartige Prozessschritte auf Dicken von wenigen Mikrometern, insbesondere wenigen Nanometern gedünnt werden.

In einem weiteren Prozessschritt zur Herstellung des Schichttransferstapels 3 wird eine Ionenart, die sich unter erhöhten Temperaturen zu einem Gas formiert, durch einen Implantationsprozess in das Halbleitersubstrat 2 eingebracht. Die Parameter des Implantationsprozesses können dabei so eingestellt werden, dass die mittlere Eindringtiefe t der Ionenart recht genau bestimmt werden kann. Bei der Ionenart handelt es sich insbesondere um Wasserstoffionen. Die Wasserstoffionen liegen dann in einer wohldefinierten Tiefe des Halbleitersubstrats 2 vor. Wasserstoffionen besitzen eine relativ geringe Masse, und können daher bei mäßiger Beschleunigung mit einer sehr geringen kinetischen Energie in das Halbleitersubstrat 2 eindringen, ohne dessen einkristalline Mikrostruktur zu zerstören. Die Wasserstoffionen werden, insbesondere unter Raumtemperatur, an das Siliziumgitter gebunden.

Figur 1a zeigt ein erstes Substrat 1, bestehend aus einem Material, insbesondere Halbleitermaterial, 4, mit einer Oberfläche 4o, sowie ein, mit einer Oxidschicht 6 beschichtetes, zweites Substrat 2 mit einem Halbleitermaterial 5. Dem zweiten Substrat 2 wurden vor der Oxidation seiner Oberfläche 5o mit der Oxidschicht 6, mit dem oben beschriebenen Implantationsprozess, Ionen, wie zum Beispiel Wasserstoffionen, in einer Tiefe t, entlang einer Schwächungsebene 7 implantiert.

In einem weiteren Prozessschritt zur Herstellung des Substratstapels 3 erfolgt die Verbondung des oxidbeschichteten Halbleitersubstrats 2 mit dem Substrat 1. Beim Bondvorgang kann es sich um einen aus dem Stand der Technik bekannten Direkt- oder Fusionsbond handeln.

Figur 1b zeigt einen Substratstapel 3, der durch das Bonden der beiden Substrate 1 und 2 über die Oberfläche 6o der Oxidschicht 6 und die Oberfläche 4o des Materials 4 erzeugt wurde. Die beiden Substrate 1 und 2 sind in einem Verbindungsbereich 18, der zwischen den beiden Substraten 1 und 2 liegt, miteinander verbunden.

Nach dem Bondvorgang erfolgt eine thermische Behandlung zur Trennung des erzeugten Substratstapels 3. Im Rahmen einer solchen thermischen Behandlung könnte die erfindungsgemäße Substratstapelhalterung und/oder das erfindungsgemäße Verfahren verwendet werden.

Bei dieser Wärmebehandlung verbinden sich die, bis zu diesem Zeitpunkt an das Gitter gebundenen, Wasserstoffatome zu Wasserstoffgas. Das Wasserstoffgas besitzt ein größeres molares Volumen als die, an das Gitter des Halbleitersubstrats gebundenen, Wasserstoffatome. Das molare Volumen des Wasserstoffgases ist allerdings auch größer als das molare Volumen der im Halbleitersubstrat vorkommenden Gitterlücken. Die Wärmebehandlung führt daher zu einem Bruch entlang der Schwächungsebene 7 des Halbleitersubstrats 2. Nach dem Bruch haftet die so erzeugte Schicht 8 mit der Oxidschicht 6 am Halbleitersubstrat 1, während der andere Teil des Halbleitersubstrats 2 abgenommen werden kann.

Figur 1c zeigt zwei neu gebildete Substratstapelteile 1' und 2' nach ihrer Trennung voneinander entlang der Schwächungsebene 7. Die Schicht 8 mit der Schichtoberfläche 8o wurde vom Halbleitermaterial 5' des Substrats 2 mit der Oberfläche 5o' entlang der Schwächungsebene 7 entfernt. Durch den Bond der Schicht 8 mit dem Halbleitersubstrat 4 über das Oxid 6 entsteht das SOI Substratstapelteil 1', während das neu gebildete, durch Entfernung der Schicht 8, verkleinerte Substratstapelteil 2' als Restsubstrat übrig bleibt. Das Substratstapelteil 2' kann in weiteren Prozessschritten erneut durch Ionenimplantation mit einer weiteren Schwächungsebene versehen, danach oxidiert und wiederverwendet werden.

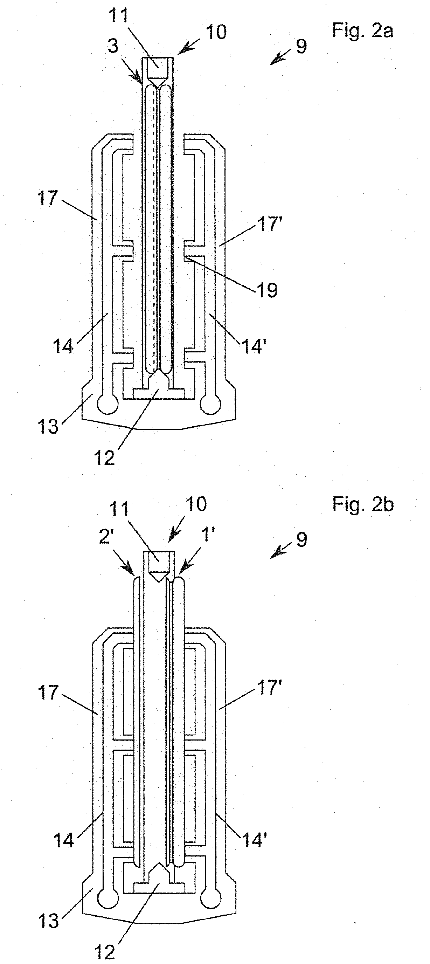

Figur 2a zeigt die Vorderansicht eines Schnitts einer erfindungsgemäßen Ausführungsform einer Substratstapelhalterung 9 mit einem Substratstapel 3, insbesondere wie in der Figur 1b gezeigt, während die Substratstapelhalterung 9 den Substratstapel 3, der noch nicht getrennt ist, fixiert. Diese Situation kann beispielsweise vor der Wärmebehandlung zum Trennen des Substratstapels 3 auftreten.

Die Substratstapelhalterung 9 weist ein horizontal angeordnetes Gerüst 13 auf, auf dem ein Podest 12 fest verbunden angeordnet ist. Das Podest 12 ist, an der Stelle, an der der Substratstapel 3 aufliegt, keilförmig ausgebildet. Die Substratstapelhalterung 9 weist weiterhin zwei Gerüstarme 17, 17' auf, die sich in vertikaler Richtung erstrecken. Die beiden Gerüstarme 17, 17' sind parallel zueinander angeordnet und bilden zwischen sich einen Aufnahmeraum für den Substratstapel 3. Der Substratstapel 3 ist vertikal im Aufnahmeraum zwischen den Gerüstarmen 17, 17' angeordnet und liegt hochkant mit seinem Verbindungsbereich 18 auf dem keilförmigen Podest 12 auf. Die Gerüstarme 17, 17' erstrecken sich auf beiden Seiten des Substratstapels 3 und sind von der Oberfläche des Substratstapels 3 beabstandet. Die Gerüstarme 17, 17' weisen jeweils Fixierelemente, insbesondere Ansaugöffnungen 19, die mit, insbesondere unabhängig voneinander schaltbaren, Vakuumleitungen 14, 14' verbunden sind. Die Substratstapelhalterung 9 weist weiterhin einen keilförmig ausgebildeten Klemmarm 11 auf, der den Substratstapel 3 an seiner Oberseite im Verbindungsbereich 18 des Substratstapels 3 fixiert bzw. festklemmt.

Figur 2b zeigt schematisch die Substratstapelhalterung 9 aus der Figur 2a, wobei der Substratstapel 3 durch eine Wärmebehandlung entlang seiner Schwächungsebene 7 (in Figur 2a gestrichelt dargestellt) in die beiden Substratstapelteile 1', 2' aufgetrennt worden ist. Figur 2b zeigt insbesondere eine Situation, die zeitlich gesehen nach der Situation aus der Figur 2a auftritt. Die Substratstapelteile 1', 2' wurden voneinander separiert und liegen an den Fixierelementen, insbesondere Ansaugöffnungen 19, der Gerüstarme 17, 17' an, wobei sie über die Vakuumbahnen 14, 14' angesaugt werden. Die Separierung wird durch die keilförmige Ausbildung des Klemmarms 11 und des Podests 12 bewirkt, wobei der Klemmarm 11 die beiden Substratstapelteile 1', 2' durch seine radial nach innen bzw. unten wirkende Klemmkraft auseinander drückt. Die Substratstapelteile 1', 2' werden von den Ansaugöffnungen 19 bzw. den Vakuumleitungen 14, 14' angesaugt und im Bereich der Ansaugöffnungen 19 an den Gerüstarmen 17, 17' fixiert. Nachdem die Substratstapelteile 1', 2' von den Gerüstarmen 17, 17' fixiert worden sind, können sie in einem darauf folgenden Schritt aus der Substratstapelhalterung 9 entnommen werden.

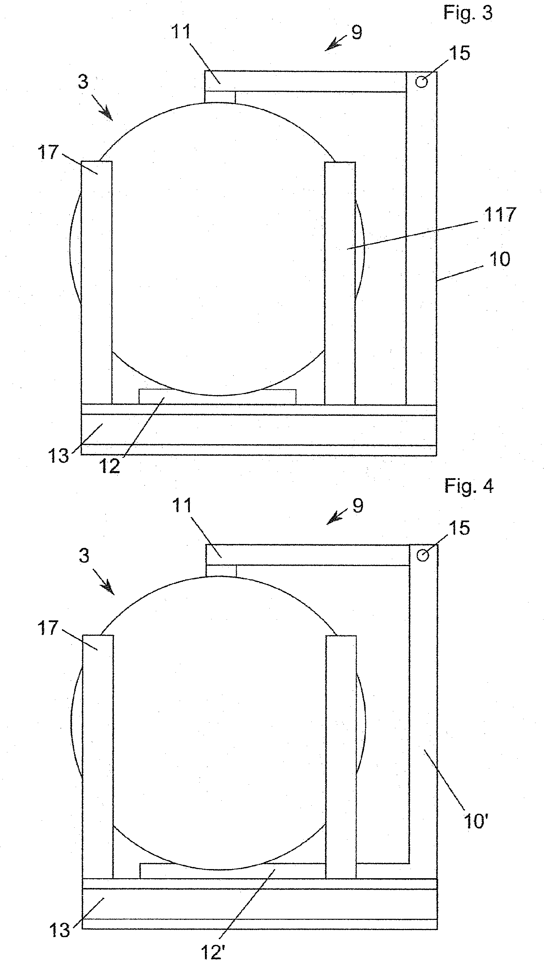

Figur 3 zeigt eine Seitenansicht einer anderen erfindungsgemäßen Ausführungsform einer Substratstapelhalterung 9. In dieser Ausführungsform weist die Substratstapelhalterung 9 auf jeder Seite des Substratstapels 3 zwei Gerüstarme 17, 117 auf. In Bezug auf den Substratstapel 3 ist der eine Gerüstarme 17 im vorderen Bereich des Substratstapels 3 angeordnet und der andere Gerüstarm 117 ist im hinteren Bereich des Substratstapels 3 angeordnet. In dieser Ausführungsform ist der Klemmarm 11 über ein Gelenk 15 mit einer vertikal angeordneten Halterungsstange 10 verbunden. Der Klemmarm 11 kann dadurch zum Beladen des Substratstapels 3 in die Substratstapelhalterung 9 nach oben und nach der Beladung wieder nach unten geklappt werden, sodass der Klemmarm 11, insbesondere durch sein Eigengewicht, den Substratstapel 3 in seinem Verbindungsbereich 18 festklemmen kann. In dieser Klemmposition ist der Klemmarm 11 insbesondere horizontal angeordnet. Außerdem weist die Substratstapelhalterung 9 ein auf dem Gerüst 13 horizontal angeordnetes Podest 12 auf, das dem Klemmarm 11 gegenüberliegt und den Substratstapel 3 in seinem Verbindungsbereich 18 von unten fixiert. In dieser Ausführungsform ist das Podest 12 als eigenes Bauteil ausgebildet und nicht mit der Halterungsstange 10 verbunden. Im Übrigen wird auf die Ausführungen zu den Figuren 2a und 2b verwiesen.

Figur 4 zeigt eine Seitenansicht einer anderen erfindungsgemäßen Ausführungsform der Substratstapelhalterung 9. Diese Ausführungsform entspricht im Wesentlichen der Ausführungsform aus der Figur 3. Im Unterschied zur Figur 3 ist in der Figur 4 das Podest 12' einstückig mit der Halterungsstange 10' verbunden, wobei das Podest 12' und die Halterungsstange 10' einen rechten Winkel bilden. Bei dieser Ausführungsform kann vorteilhaft die Befestigung der Halterungsstange 10' am Gerüst 13 verbessert werden. Im Übrigen wird auf die Ausführungen zur Figur 3 verwiesen.

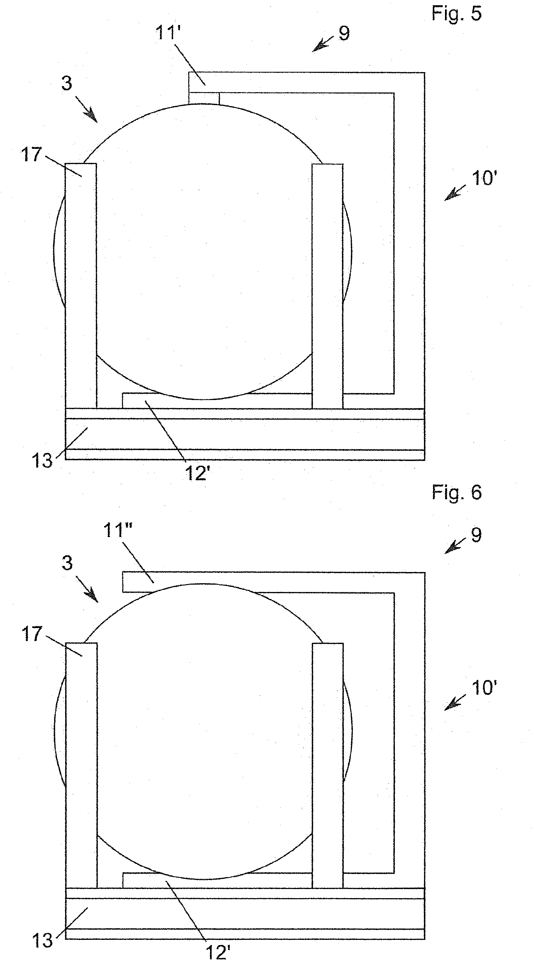

Figur 5 zeigt eine andere erfindungsgemäße Ausführungsform eines Substratstapelhalterung 9, in welcher das Podest 12, die Halterungsstange 10' und der Klemmarm 11' einstückig aus einem einzigen Bauteil gefertigt ist. Der Klemmarm 11' wird nicht mehr durch ein Gelenk 15, sondern durch seine Elastizität aus seiner Ruhelage ausgelenkt. Zur Beladung wird der Substratstapel 3 zwischen das Podest 12' und den Klemmarm 11' eingeführt, wobei der Klemmarm 11' aufgrund seiner Elastizität nach oben gedrückt werden kann. Aufgrund dieser Klemmkraft wird der Substratstapel 3 durch den Klemmarm 11' festgeklemmt. Diese Ausführungsform ermöglicht eine vergleichsweise einfache Beladung des Substratstapels 3 in die Substratstapelhalterung 9. Im Übrigen ist die Substratstapelhalterung 9 aufgebaut wie in der Figur 4, sodass auf die obigen Ausführungen verwiesen werden kann.

Figur 6 zeigt eine andere erfindungsgemäße Ausführungsform einer Substratstapelhalterung 9, in welcher das Podest 12, die Halterungsstange 10' und der Klemmarm 11" aus einem einzigen Bauteil gefertigt wurden und ein U-förmiges Bauteil bilden, wobei die Öffnung des U in die horizontale Richtung zeigt. Im Vergleich zur Figur 5 ist hier der Klemmarm 11" gleichartig wie das Podest 12' ausgebildet. Diese erfindungsgemäße Ausführungsform eignet sich insbesondere für die Lagerung des Substratstapelhalters 9 in horizontaler und/oder vertikaler Lage. Die Halterungsstange 10' mit dem Podest 12' und dem Klemmarm 11" stellen eine elastische Gabel mit zwei Zinken 11" und 12' dar, welche den Substratstapel 3 durch eine entsprechende elastische Vorspannung, wie bereits in der Figur 5 für den Klemmarm 11' beschrieben, fixiert.

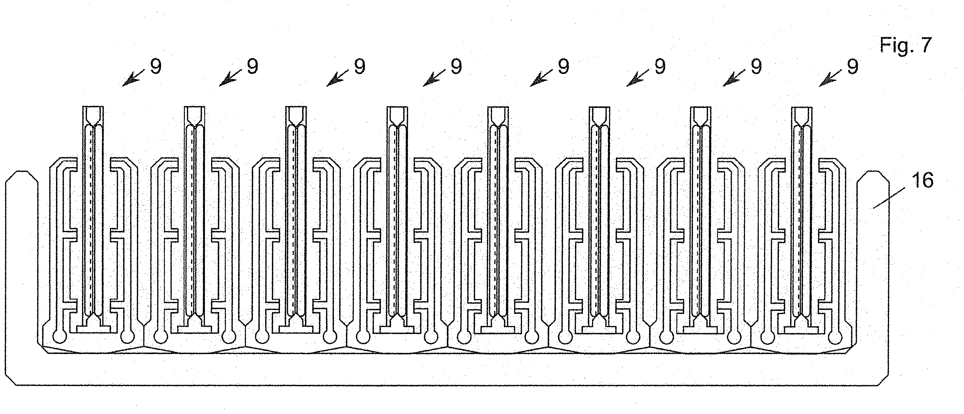

Figur 7 zeigt einen erfindungsgemäßen Container 16, der mehrere Substratstapelhalterungen 9 aufnimmt, beispielsweise um sie transportieren zu können. Entsprechende Verbindungselemente, mit deren Hilfe die Vakuumleitungen 14, 14' gesteuert werden können, sind nicht eingezeichnet. Um eine Verbindung zwischen den Vakuumleitungen 14, 14' und dem Container 16 herzustellen, weisen die Substratstapelhalterungen 9 entsprechende Schnittstellen oder Adapter auf. Diese sind der Übersichtlichkeit halber nicht eingezeichnet. Die Ansteuerung der Vakuumleitungen 14, 14' der Substratstapelhalterungen 9 kann entweder einzeln oder gemeinsam erfolgen. Bei dem Container 16 kann es sich insbesondere um eine spezielle, adaptierte Waferbox handeln.

### Bezugszeichenliste

- 1: Substrat
- 1': Erstes Substratstapelteil
- 2: Substrat
- 2': Zweites Substratstapelteil
- 3: Substratstapel
- 4: Halbleitermaterial
- 4o: Substratoberfläche
- 5, 5': Halbleitermaterial
- 5o, 5o': Substratoberfläche
- 6: Oxidschicht
- 6o: Oxidschichtoberfläche
- 7: Schwächungsebene
- 8: Schicht
- 8o: Schichtoberfläche
- 9: Substratstapelhalterung
- 10, 10': Halterungsstange
- 11, 11', 11": Klemmarm
- 12, 12': Podest
- 13: Gerüst
- 14, 14': Vakuumleitungen
- 15: Gelenk
- 16: Container
- 17, 17', 117: Gerüstarme
- 18: Verbindungsbereich
- 19: Ansaugöffnungen
- t: Eindringtiefe

## Patentansprüche

1. Substratstapelhalterung (9), aufweisend:
- eine Halte- und Separiereinrichtung (11, 11', 11", 12, 12'), ausgebildet zur Halterung eines Substratstapels (3) während eines Trennvorgangs in Substratstapelteile (1', 2') und zur Separierung der Substratstapelteile (1', 2') voneinander nach dem Trennvorgang,
- eine Fixiereinrichtung (17, 17', 117), ausgebildet zur Aufnahme und Befestigung der separierten Substratstapelteile (1', 2') nach dem Trennvorgang, **dadurch gekennzeichnet, dass** die Fixiereinrichtung (17, 17', 117) auf jeder Seite des Substratstapels (3) mindestens einen parallel zum Substratstapel (3) angeordneten Gerüstträger (17, 17', 117) mit Fixierelementen (19) zur Aufnahme und Befestigung der separierten Substratstapelteile (1', 2') aufweist, wobei die Gerüstträger (17, 17', 117) vor dem Trennvorgang von der Oberfläche des Substratstapels (3) beabstandet sind.

2. Substratstapelhalterung (9) nach Anspruch 1, **dadurch gekennzeichnet, dass** die Halte- und Separiereinrichtung (11, 11', 11", 12, 12') mindestens einen, insbesondere keilförmig ausgebildeten, Klemmarm (11, 11', 11") aufweist, der den Substratstapel (3) radial von außen in einem Verbindungsbereich (18) des Substratstapels (3) festklemmbar ausgebildet ist.

3. Substratstapelhalterung (9) nach einem der vorhergehenden Ansprüche, **dadurch gekennzeichnet, dass** die Halte- und Separiereinrichtung (11, 11', 11", 12, 12') ein, insbesondere keilförmig ausgebildetes, Podest (12, 12') aufweist, auf das der Substratstapel (3) in seinem Verbindungsbereich (18), insbesondere hochkant, auflegbar ist.

4. Substratstapelhalterung (9) nach Anspruch 2 und/oder 3, **dadurch gekennzeichnet, dass** der Klemmarm (11, 11', 11") und/oder das Podest (12, 12') einen Keilwinkel größer als 15°, vorzugsweise größer als 45°, noch bevorzugter größer als 75°, am bevorzugtesten größer als 105°, am allerbevorzugtesten größer als 135° aufweist/aufweisen.

5. Substratstapelhalterung (9) nach Anspruch 1, **dadurch gekennzeichnet, dass** die Fixierelemente (19) als mit Vakuumleitungen (14, 14') verbundene Ansaugöffnungen (19) zum Ansaugen der Substratstapelteile (1', 2') ausgebildet sind.

6. Substratstapelhalterung (9) nach einem der vorhergehenden Ansprüche, **dadurch gekennzeichnet, dass** die Substratstapelhalterung (9) zur vertikalen Aufnahme des Substratstapels (3) ausgebildet ist.

7. Container (16), aufweisend eine Vielzahl an, insbesondere horizontal nebeneinander angeordneten, Substratstapelhalterungen (9) nach einem der vorhergehenden Ansprüche.

8. Verfahren zur Trennung eines Substratstapels (3), insbesondere eines Schichttransferstapels, aufweisend die folgenden Schritte, insbesondere den folgenden Ablauf:
a) Beladung des Substratstapels (3) in eine Substratstapelhalterung (9) nach einem der Ansprüche 1 bis 6, und Halterung des Substratstapels (3) in der Substratstapelhalterung (9),
b) Wärmebehandlung des Substratstapels (3) zum Trennen in zwei Substratstapelteile (1', 2') entlang einer Schwächungsebene (7),
c) Separierung der Substratstapelteile (1', 2') voneinander,
d) Aufnahme und Befestigung der voneinander getrennten Substratstapelteile (1', 2') durch eine Fixiereinrichtung (17, 17', 117) der Substratstapelhalterung (9),
e) Entladung der getrennten Substratstapelteile (1', 2') von der Substratstapelhalterung (9).

9. Verfahren nach Anspruch 8, **dadurch gekennzeichnet, dass** in Schritt b) die Wärmebehandlung in einem Ofen, insbesondere in einem Durchlaufofen, erfolgt, wobei der Substratstapel (3) auf eine Temperatur größer 25 °C, vorzugsweise größer 100 °C, noch bevorzugter größer 250 °C, am bevorzugtesten größer 500 °C, am allerbevorzugtesten größer 750 °C geheizt wird.

10. Verfahren nach Anspruch 9, **dadurch gekennzeichnet, dass** in Schritt b) der Ofen mit einem Gas gespült wird, wobei die Wärmeleitfähigkeit des Gases größer ist 0,01 W/(m^{∗}K), bevorzugt größer als 0,1 W/(m^{∗}K), bevorzugter größer als 1 W/(m^{∗}K) ist.

11. Verfahren nach einem der Ansprüche 8 bis 10, **dadurch gekennzeichnet, dass** im Schritt d) die Substratstapelteile (1', 2') durch in der Fixiereinrichtung (17, 17', 117) angeordnete Vakuumleitungen (14, 14') angesaugt werden.

12. Verfahren nach einem der Ansprüche 8 bis 11, **dadurch gekennzeichnet, dass** der Substratstapel (3) vertikal in der Substratstapelhalterung (9) angeordnet wird.

13. Verwendung einer Substratstapelhalterung (9) gemäß einem der Ansprüche 1 bis 6 zur Trennung eines Substratstapels (3), insbesondere gemäß einem Verfahren nach einem der Ansprüche 8 bis 12.

## Claims

1. A substrate stack holder (9), comprising:
- a holding and separating device (11, 11', 11", 12, 12'), designed for holding a substrate stack (3) during a separation process into substrate stack parts (1', 2') and for separating of the substrate stack parts (1', 2') from one another after the separation process,
- a fixing device (17, 17', 117), designed for receiving and fixing the separated substrate stack parts (1', 2') after the separation process, **characterised in that** the fixing device (17, 17', 117) comprises on each side of the substrate stack (3) at least one framework support (17, 17', 117) arranged parallel to the substrate stack (3) with fixing elements (19) for receiving and fixing the separated substrate stack parts (1', 2'), wherein the framework support (17, 17', 117) is spaced apart from the surface of the substrate stack (3) before the separation process.

2. The substrate stack holder (9) according to claim 1, **characterised in that** the holding and separating device (11, 11', 11", 12, 12') comprises at least one, in particular wedge-shaped, clamping arm (11, 11', 11"), which is designed capable of clamping the substrate stack (3) radially from the exterior in a connection region (18) of the substrate stack (3).

3. The substrate stack holder (9) according to any one of the preceding claims, **characterised in that** the holding and separating device (11, 11', 11", 12, 12') comprises a, in particular wedge-shaped, platform (12, 12'), on which the substrate stack (3) can be placed, in particular on edge, in its connection region (18).

4. The substrate stack holder (9) according to claim 2 and/or 3, **characterised in that** the clamping arm (11, 11', 11") and/or the platform (12, 12') has/have a wedge angle greater than 15°, preferably greater than 45°, still more preferably greater than 75°, most preferably greater than 105°, with utmost preference greater than 135°.

5. The substrate stack holder (9) according to claim 1, **characterised in that** the fixing elements (19) are designed as suction openings (19) connected to vacuum lines (14, 14') for applying suction to the substrate stack parts (1', 2').

6. The substrate stack holder (9) according to any one of the preceding claims, **characterised in that** the substrate stack holder (9) is designed for receiving the substrate stack (3) vertically.

7. A container (16), comprising a plurality of substrate stack holders (9) according to any one of the preceding claims, arranged in particular horizontally beside one another.

8. A method for the separation of a substrate stack (3), in particular of a layer transfer stack, comprising the following steps, in particular in the following sequence:
a) loading of the substrate stack (3) into a substrate stack holder (9) according to any one of claims 1 to 6, and holding of the substrate stack (3) in the substrate stack holder (9),
b) heat treatment of the substrate stack (3) for the separation into two substrate stack parts (1', 2') along a weakening plane (7),
c) separation of the substrate stack parts (1', 2') from one another,
d) receiving and fixing of the substrate stack parts (1', 2') separated from one another by means of a fixing device (17, 17', 117) of the substrate stack holder (9),
e) unloading of the separated substrate stack parts (1', 2') from the substrate stack holder (9).

9. The method according to claim 8, **characterised in that** in step b) the heat treatment takes place in a furnace, in particular a through-type furnace, wherein the substrate stack (3) is heated to a temperature greater than 25°C, preferably greater than 100°C, still more preferably greater than 250°C, most preferably greater than 500°C, with utmost preference greater than 750° C.

10. The method according to claim 9, **characterised in that** in step b) the furnace is flushed with a gas, wherein the thermal conductivity of the gas is greater than 0.01 W/(m^{∗}K), preferably greater than 0.1 W/(m^{∗}K), more preferably greater than 1 W/(m^{∗}K).

11. The method according to any one of claims 8 to 10, **characterised in that** in step d) the substrate stack parts (1', 2') are subjected to suction by vacuum lines (14, 14') arranged in the fixing device (17, 17', 117).

12. The method according to any one of claims 8 to 11, **characterised in that** the substrate stack (3) is arranged vertically in the substrate stack holder (9).

13. Use of a substrate stack holder (9) according to any one of claims 1 to 6 for the separation of a substrate stack (3), in particular according to a method according to any one of claims 8 to 12.

## Revendications

1. Support de pile de substrats (9), présentant :
- un dispositif de fixation et de séparation (11, 11', 11", 12, 12') conçu pour supporter une pile de substrats (3) pendant une procédure de séparation en parties (1', 2') de piles de substrats et pour séparer les parties (1', 2') de piles de substrats l'une de l'autre après la procédure de séparation,
- un dispositif de fixation (17, 17', 117) conçu pour recevoir et fixer les parties (1', 2') de piles de substrats séparées après la procédure de séparation, **caractérisé en ce que** le dispositif de fixation (17, 17', 117) présente sur chaque côté de la pile de substrats (3) au moins un support de cadre (17, 17', 117) disposé parallèlement à la pile de substrats (3) avec des éléments de fixation (19) pour recevoir et fixer les parties (1', 2') de piles de substrats séparées, dans lequel les supports de cadre (17, 17', 117) sont distants de la surface de la pile de substrats (3) avant la procédure de séparation.

2. Support de pile de substrats (9) selon la revendication 1, **caractérisé en ce que** le dispositif de fixation et de séparation (11, 11', 11", 12, 12') présente au moins un bras de serrage (11, 11', 11") conçu au moins cunéiforme, qui est conçu pouvant serrer la pile de substrats (3) radialement de l'extérieur dans une zone de liaison (18) de la pile de substrats (3).

3. Support de pile de substrats (9) selon l'une des revendications précédentes, **caractérisé en ce que** le dispositif de fixation et de séparation (11, 11', 11", 12, 12') présente un socle (12, 12') conçu en particulier cunéiforme sur lequel la pile de substrats (3) peut être placée, en particulier verticalement, dans sa zone de liaison (18).

4. Support de pile de substrats (9) selon la revendication 2 et/ou 3, **caractérisé en ce que** le bras de serrage (11, 11', 11") et/ou le socle (12, 12') présente(nt) un angle de taillant supérieur à 15°, de préférence supérieur à 45°, de manière plus préférée supérieur à 75°, de manière la plus préférée supérieur à 105°, de manière préférée entre toutes supérieur à 135°.

5. Support de pile de substrats (9) selon la revendication 1, **caractérisé en ce que** les éléments de fixation (19) sont conçus en tant qu'ouvertures d'aspiration (19) reliées à des lignes de vide (14, 14') pour aspirer les parties (1', 2') de piles de substrats.

6. Support de pile de substrats (9) selon l'une des revendications précédentes, **caractérisé en ce que** le support de pile de substrats (9) est conçu pour la préhension verticale de la pile de substrats (3).

7. Récipient (16), présentant une pluralité de supports de pile de substrats (9) selon l'une des revendications précédentes, disposés en particulier horizontalement les uns à côté des autres.

8. Procédé destiné à la séparation d'une pile de substrats (3), en particulier d'une pile de transfert de couches, présentant les étapes suivantes, en particulier le déroulement suivant :
a) chargement de la pile de substrats (3) dans un support de pile de substrats (9) selon l'une des revendications 1 à 6 et fixation de la pile de substrats (3) dans le support de pile de substrats (9),
b) traitement thermique de la pile de substrats (3) pour la séparation en deux parties (1', 2') de piles de substrats le long d'un plan d'affaiblissement (7),
c) séparation des parties (1', 2') de piles de substrats l'une de l'autre,
d) réception et fixation des parties (1', 2') de piles de substrats séparées l'une de l'autre par un dispositif de fixation (17, 17', 117) du support de pile de substrats (9),
e) déchargement des parties (1', 2') de piles de substrats séparées du support de pile de substrats (9).

9. Procédé selon la revendication 8, **caractérisé en ce qu'**à l'étape b), le traitement thermique est effectué dans un four, en particulier dans un four continu, dans lequel la pile de substrats (3) est chauffée à une température supérieure à 25°C, de préférence supérieure à 100°C, plus encore de préférence supérieure à 250°C, de manière la plus préférée supérieure à 500°C, de manière préférée entre toutes supérieure à 750°C.

10. Procédé selon la revendication 9, **caractérisé en ce qu'**à l'étape b), le four est rincé avec un gaz, dans lequel la conductivité thermique du gaz est de 0,01 W/(m^{∗}K), de préférence supérieure à 0,1 W/(m^{∗}K), plus encore de préférence supérieure à 1 W/(m^{∗}K).

11. Procédé selon l'une des revendications 8 à 10, **caractérisé en ce qu'**à l'étape d), les parties (1', 2') de piles de substrats sont aspirées par des lignes de vide (14, 14') disposées dans le dispositif de fixation (17, 17', 117).

12. Procédé selon l'une des revendications 8 à 11, **caractérisé en ce que** la pile de substrats (3) est disposée verticalement dans le support de pile de substrats (9).

13. Utilisation d'un support de pile de substrats (9) selon l'une des revendications 1 à 6 pour la séparation d'une pile de substrats (3), en particulier selon un procédé selon l'une des revendications 8 à 12.
